# EUROPÄISCHE PATENTSCHRIFT

(11) **EP 2 810 087 B1**
(45) Veröffentlichungstag und Bekanntmachung des Hinweises auf die Patenterteilung: **07.12.2022**
(21) Anmeldenummer: 13707375.5
(22) Anmeldetag: 01.03.2013
(51) Int. Cl.: H02B 13/035, G01R 15/14

(54) **MESSWANDLERANORDNUNG**
MEASURING TRANSDUCER ARRANGEMENT
SYSTÈME DE CONVERTISSEUR DE MESURE

(30) Priorität: 16.03.2012 DE 102012204179
(43) Veröffentlichungstag der Anmeldung: 10.12.2014
(73) Patentinhaber: Siemens Energy Global GmbH & Co. KG, 81739 München (DE)
(72) Erfinder: HAIN, Stefan, 91090 Effeltrich (DE); MILEWSKI, Peter, 12355 Berlin (DE); OLSZEWSKI, Wojciech, 13629 Berlin (DE)
(86) Internationale Anmeldenummer: PCT/EP2013/054183
(87) Internationale Veröffentlichungsnummer: WO 2013/135506

(56) Entgegenhaltungen:
- EP-A1- 2 253 963
- DE-A1- 3 544 508
- US-A- 3 943 433

## Beschreibung

Die Erfindung bezieht sich auf eine Messwandleranordnung aufweisend einen Spannungssensor und einen Stromsensor, wobei der Spannungssensor eine Messelektrode zum Erfassen einer elektrischen Spannung aufweist, wobei die Messelektrode ringförmig ausgeformt ist und eine Aufnahme aufweist, in welcher eine Sonde des Stromsensors positioniert ist.

Eine derartige Messwandleranordnung ist beispielsweise aus der Patentschrift CH 682190 A5 bekannt. Die dortige Messwandleranordnung weist einen Spannungssensor und einen Stromsensor auf, wobei der Spannungssensor eine Messelektrode zum Erfassen einer elektrischen Spannung aufweist. Stromsensor und Spannungssensor sind im Wesentlichen koaxial zueinander ausgerichtet und relativ zueinander über einen Isolierkörper fixiert. Um ein störungsfreies Arbeiten von Stromsensor und Spannungssensor zu gewährleisten, ist eine Abschirmelektrode vorgesehen, über welche der Stromsensor von der Messelektrode dielektrisch separiert ist. Um die bekannte Messwandleranordnung in einer metallgekapselten gasisolierten Hochspannungsanlage anzuordnen, sind zusätzliche Schirmelektroden vorgesehen, welche die Messwandleranordnung schirmen.

Somit ergibt sich eine Messwandleranordnung, welche aus einer Vielzahl einzelner Baugruppen zusammengesetzt ist, wobei im Zusammenwirken der Baugruppen ein winkelstarrer Verbund gegeben ist. Insbesondere ein Einsatz der bekannten Messwandleranordnung an mehrphasig gekapselten Schaltanlagen erscheint nur erschwert unmöglich, da sich die bekannte Anordnung an einem Gehäuse ringförmig innenmantelseitig um einen zentral geführten Phasenleiter herum erstreckt.

Aus der Offenlegungsschrift DE 35 44 508 A1 ist ein Kombinationswandler zum gleichzeitigen Messen von Strom und Spannung an rohrummantelten Leitern bekannt, bei welchem eine Rogowskispule vor elektrischen Feldern durch eine geschlitzte Metallfolie geschützt ist. Um die Rogowskispule nebst Metallfolie zu positionieren, ist die Rogowskispule in einen Metallring eingesetzt, wobei der Metallring die Rogowskispule außenmantelseitig umgreift. Eine derartige Konstruktion weist zwar eine dielektrisch günstige Gestalt auf, jedoch ist eine derartige Konstruktion auf Grund der zu erzielenden Verspann- und Haltekräfte aufwändig zu fertigen.

Eine weitere Messwandleranordnung ist aus der Europäischen Patentanmeldung EP 2 253 963 A1 bekannt. Dort ist eine Messwandleranordnung beschrieben, welche einen Spannungssensor sowie einen Stromsensor aufweist, wobei der Spannungssensor eine Messelektrode zum Erfassen einer elektrischen Spannung aufweist. Die dortige Messelektrode ist in Form einer Beschichtung aus einem leitenden oder halbleitenden Material auf einer äußeren Mantelfläche eines hohlzylindrischen elektrisch isolierenden Substrats ausgebildet. Bevorzugt ist diese Beschichtung als Elastomer ausgeführt. Die Strommesseinrichtung ist über die Beschichtung aus elektrisch leitendem bzw. halbleitendem Material mit dem elektrisch isolierenden Substrat verklebt. Zwar ermöglicht ein Verkleben ein spaltfreies Verbinden von Spannungssensor und Stromsensor, ein derartiges Verbinden ist jedoch fertigungstechnisch ebenfalls aufwändig.

Aus dem US-Patent US 3,943,433 geht ein Messwandler hervor, welcher innerhalb einer metallgekapselten Hochspannungsanlage angeordnet ist.

Damit ergibt sich als Aufgabe der Erfindung, eine Messwandleranordnung anzugeben, welche bei einem vereinfachten Aufbau einen vereinfachten Fertigungsprozess ermöglicht.

Damit ergibt sich als Aufgabe der Erfindung eine Messwandleranordnung anzugeben, welche vereinfacht aufgebaut ist.

Erfindungsgemäß wird die Aufgabe bei einer Messwandleranordnung der eingangs genannten Art dadurch gelöst, dass die Aufnahme als Ausnehmung in der Messelektrode ausgeformt und außenmantelseitig an der Messelektrode angeordnet ist und die Messelektrode und die Sonde in einem Isolierkörper eingebettet sind, welcher ein Stützisolator der/des Phasenleiter(s) ist.

Eine Messwandleranordnung ist eine Anordnung, welche einem Erfassen einer elektrischen Spannung und/oder eines elektrischen Stromes dient. Ein Phasenleiter kann beispielsweise mit einer Spannung beaufschlagt werden, welche von dem Spannungssensor der Messwandleranordnung erfasst werden kann. Weiterhin kann der Phasenleiter getrieben durch die elektrische Spannung einen elektrischen Strom führen, wobei der elektrische Strom von dem Stromsensor erfasst werden kann. Messwandleranordnungen sind beispielsweise dann einzusetzen, wenn eine unmittelbare Spannungs- und/oder Strommessung am Phasenleiter nicht vorgenommen werden kann. Dies kann beispielsweise dann der Fall sein, wenn der Phasenleiter schwer zugänglich ist oder wenn die Beträge von Strom oder Spannung derart hoch sind, dass zunächst eine Wandlung des Stromes bzw. der Spannung in verarbeitbare Größen erfolgen muss. Eine Abbildung von Strom oder Spannung kann beispielsweise erfolgen, indem eine den Strom bzw. die Spannung abbildende physikalische Größe mittels des Stromsensors bzw. des Spannungssensors erfasst und gewandelt wird. Ein derartiges Erfassen und Wandeln kann beispielsweise unter Nutzung des transformatorischen Prinzips erfolgen. Es kann jedoch auch vorgesehen sein, dass beispielsweise ein Ladungszustand des Phasenleiters erfasst wird. So kann beispielsweise ein kapazitiver Spannungsteiler unter Nutzung der Messelektrode des Spannungssensors aufgebaut werden, so dass ein Abbild des elektrischen Potentials des Phasenleiters geliefert werden kann. Die Messelektrode weist eine als Kondensatorbelag wirkende Elektrodenfläche auf, so dass die Messelektrode ein schwimmendes Potential führt. Die Abbilder von Strom und/oder Spannung können beispielsweise in Form eines weiterverarbeitbaren Messsignals z. B. als Datentelegramm von der Messstelle, an welcher die Messwandleranordnung befindlich ist, zu einer Verarbeitungsstelle, an welcher eine Auswertung, Umsetzung, Anzeige, Weiterverarbeitung usw. der durch die Messwandleranordnung gelieferten Messwerte erfolgt, vorliegen. Vorteilhafterweise kann vorgesehen sein, dass die Messelektrode des Spannungssensors innerhalb eines elektrischen Feldes positioniert ist, welches den Phasenleiter umgibt. Der Phasenleiter kann beispielsweise unter Hochspannung stehen, wobei sich die Hochspannung bezüglich eines beispielsweise geerdeten Neutralpunktes entlang eines Isoliermediums abbaut. Zwischen dem geerdeten Neutralpunkt und dem Phasenleiter ist die Messelektrode angeordnet, so dass ein kapazitiver Spannungsteiler gebildet werden kann und die Aufladung der Messelektrode ein Abbild eines an diesem kapazitiven Spannungsteiler auftretenden Spannungsfalles darstellt. Die Messelektrode nimmt ein schwimmendes Potential an.

Zur Ausgestaltung des Stromsensors kann eine Nutzung eines transformatorischen Prinzips vorgesehen sein, wobei ein zu überwachender Phasenleiter als Primärwicklung dient und der Stromsensor eine Sekundärwicklung aufweist. Beispielsweise kann die Sekundärwicklung des Stromsensors den Phasenleiter umgreifen bzw. der Phasenleiter kann die Sekundärwicklung durchsetzen.

Sowohl die Messelektrode als auch der Stromsensor sind bezüglich des zu überwachenden Stromes bzw. der zu überwachenden Spannung in einer bestimmten räumlichen Anordnung zueinander zu positionieren. Bei einer definierten Raumanordnung ist eine zuverlässige Messung des Stromes und/oder der Spannung möglich. Nutzt man nunmehr die Messelektrode des Spannungssensors zur Positionierung des Stromsensors, ist eine Lage von der Messelektrode des Spannungssensors sowie der Sonde des Stromsensors vorgegeben. Die Aufnahme bietet einen Anlagepunkt für die Sonde, um Messelektrode und Sonde zueinander festzulegen. Beispielsweise kann die Sonde formschlüssig und/oder stoffschlüssig an der Messelektrode festgelegt werden. Die Sonde kann in der Aufnahme gehalten werden. Die Sonde kann so in ihrer Lage zur Messelektrode festgelegt sein. Ein unbeabsichtigtes Entfernen der Sonde von der Messelektrode wird erschwert. Die Messelektrode sollte eine Aufnahme aufweisen, in welcher Sonde und Messelektrode ineinander greifen. Vorteilhaft könnte eine formschlüssige Festlegung der Sonde an der Messelektrode erfolgen. Als Aufnahme können verschiedenartige Ausformungen der Messelektrode vorgesehen sein. Die Aufnahme kann Anschlagpunkte, Rastpunkte usw. aufweisen. Die Aufnahme kann auch formkomplementär zu einem Abschnitt der Sonde ausgeformt sein, so dass beispielsweise die Sonde formschlüssig mit der Aufnahme verbunden ist. Weiterhin kann vorteilhaft vorgesehen sein, dass die Sonde formschlüssig in die Elektrode eingreift, so dass ein unbeabsichtigtes Bewegen der Sonde von der Messelektrode fort verhindert ist. Die Sonde kann alternativ oder zusätzlich stoffschlüssig mit der Aufnahme verbunden sein. Vorteilhafterweise sollte die Messelektrode als Stabilisierungselement für die Sonde dienen, so dass die Sonde an der Messelektrode abgestützt ist. Die Messelektrode weist beispielsweise eine winkelstarre Form auf, welche beispielsweise auch eine Formbeständigkeit der Sonde unterstützt. Beispielsweise kann eine Wicklung der Sonde sich zumindest teilweise durch die Aufnahme erstrecken, so dass die Lage der Wicklung an der Messelektrode festgelegt ist. Beispielsweise können Wickelbegrenzungen an der Messelektrode angeordnet sein, wobei sich eine Wicklung des Stromsensors zwischen den Wickelbegrenzungen erstreckt. Eine Wicklung kann sich beispielsweise schlaufenförmig durch die Aufnahme erstrecken. Neben einer Nutzung eines transformatorischen Prinzips kann beispielsweise der Stromsensor auch als so genannter optischer Stromsensor ausgebildet sein, d. h., die Sonde kann beispielsweise auch eine Wicklung mit einem Lichtwellenleiter aufweisen, welcher polarisiertes Licht führt. Durch Einwirkung eines Magnetfeldes eines einen Phasenleiter durchfließenden Stromes kann die Polarisationsebene des polarisierten Lichtes verändert werden, wobei eine Änderung des Winkels der Polarisationsebene proportional zum Betrag des zu überwachenden Stromes sein kann.

Neben einer Verwendung von Wicklungen, welche an der Messelektrode angeordnet sind, kann weiterhin der Einsatz beispielsweise von Hallsonden vorgesehen sein, welche an der Messelektrode abgestützt und positioniert sind Darüber hinaus können auch weitere Sondenbauformen an der Aufnahme der Messelektrode positioniert sein.

Eine weitere vorteilhafte Ausgestaltung kann vorsehen, dass die Sonde zumindest teilweise durch die Messelektrode dielektrisch geschirmt ist.

Die Messelektrode weist eine Elektrodenfläche auf, welche in Richtung des zu überwachenden Phasenleiters ausgerichtet ist. Die Elektrodenfläche dient als kapazitiver Belag zur Ausbildung eines kapazitiven Spannungsteilers. Entsprechend führt die Messelektrode, insbesondere die Elektrodenfläche, ein schwimmendes Potential. Im Schatten der Sonde ergibt sich gegenüber dem zu überwachenden Phasenleiter ein Raum, welcher dielektrisch durch die Messelektrode bzw. deren Elektrodenfläche geschirmt ist. Die Messelektrode, respektive die Elektrodenfläche kann dabei um eine oder mehrere Achsen gekrümmt verlaufen, so dass zum einen eine ausreichende Elektrodenfläche für den Spannungssensor gegeben ist und andererseits eine verbesserte Schirmung des geschirmten Raumes erfolgt. Entsprechend kann bei einer Anordnung der Sonde des Stromsensors innerhalb dieses dielektrisch geschirmten Raumes auf separate Schirmelektroden verzichtet werden. Die zur Spannungsmessung nötige Messelektrode kann einen kapazitiven Belag zur Verfügung stellen, um einen kapazitiven Spannungsteiler abzubilden. Weiter kann durch die dielektrischen Eigenschaften der Messelektrode zumindest abschnittsweise ein feldfreier Raum zur Verfügung gestellt werden. Innerhalb dieses Raumes kann sich nunmehr ein Teil der Sonde erstrecken, welcher beispielsweise teilentladungsgefährdet ist. Vorteilhafterweise kann sich die Sonde auch größtenteils innerhalb dieses dielektrisch geschirmten Raumes erstrecken, so dass auf zusätzliche separate Schirmungseinrichtungen für die Sonde verzichtet werden kann. Der feldfreie Raum erstreckt sich vorzugsweise auf einer von dem Phasenleiter abgewandten Seite der Messelektrode.

Eine vorteilhafte Ausgestaltung sieht vor, dass die Aufnahme als Ausnehmung in der Messelektrode ausgeformt ist.

Eine Ausnehmung in der Messelektrode bietet einen vergrößerten Raum zur Aufnahme der Sonde des Stromsensors. Durch die Ausnehmung kann der dielektrisch geschirmte Raum nicht nur aus einer einzigen Richtung geschirmt werden. Dazu kann die Ausnehmung seitliche (dielektrisch schirmende) Wandungen bereitstellen, welche die dielektrisch schirmende Wirkung der Ausnehmung verstärken. Die Elektrodenfläche sollte sich vorzugsweise auch bis auf die seitlichen Wandungen erstrecken, um auch dort eine dielektrisch schirmende Wirkung zu entfalten. Die Ausnehmung kann sich beispielsweise taschenartig in die Messelektrode hinein erstrecken. Es kann auch vorgesehen sein, dass sich die Ausnehmung nutförmig ausgekehlt in der Messelektrode erstreckt. Nutwangen bzw. Kehlwangen können zum einen einen Teil der Aufnahme ausbilden. Zum anderen können Nutwangen bzw. Kehlwangen als seitliche Wandung fungieren. Hierbei ist die Wandstärke insbesondere hinsichtlich der mechanisch tragenden Eigenschaften der Messelektrode auszulegen, da zur Ausbildung eines kapazitiven Belages an der Messelektrode lediglich ein bestimmtes Potenzial zu führen ist, welches auch an einer flächig erstreckten wandstärkearmen elektrisch aktiven Messelektrodenschicht realisiert werden kann. Beispielsweise kann die Messelektrode einen elektrisch isolierenden Tragkörper aufweisen, der lediglich dünnwandige Beschichtungen zur Ausbildung eines kapazitiven Belages/der Elektrodenfläche aufweist.

Eine weitere vorteilhafte Ausgestaltung sieht vor, dass die Messelektrode ringförmig ausgeformt ist und die Aufnahme außenmantelseitig an der Messelektrode angeordnet ist.

Eine ringförmige Messelektrode kann vorteilhafterweise von einem Phasenleiter durchsetzt werden, so dass eine ringförmige Elektrodenfläche der Messelektrode dem Phasenleiter zugewandt ist. Diese ringförmige innenmantelseitige Fläche dient als kapazitiver Belag/Elektrodenfläche zur Ausbildung eines kapazitiven Spannungsteilers. Die innenmantelseitige Fläche kann neben einer Krümmung in Umlaufrichtung des Ringes auch quer dazu gekrümmt sein. So kann die Fläche beispielsweise einem Ausschnitt einer Oberfläche eines Toroides entsprechen, wobei der Toroid beliebig profiliert sein kann. Es ist vorteilhaft, wenn sich außenmantelseitig an der Messelektrode die Ausnehmung erstreckt, so dass die dem Phasenleiter zugewandte Fläche unabhängig von Form bzw. Vorhandensein einer Ausnehmung an der Messelektrode gleichbleibend kontinuierlich vorsprungsfrei ausgeformt ist. Die Messelektrode sollte vorzugsweise in sich geschlossen ringförmig umlaufend ausgeformt sein. Es kann jedoch auch vorgesehen sein, dass die Messelektrode lediglich als Sektor eines einen Phasenleiter umgreifenden Ringes ausgeführt ist. Beispielsweise kann ein derartiger Ringsektor innenmantelseitig dem Phasenleiter zugewandt sein und an einer außenmantelseitigen Fläche die Ausnehmung aufweisen. Je nach Ausgestaltung der Sonde des Stromsensors kann die Form der Aufnahme variabel ausgestaltet sein. Eine ringförmige Messelektrode kann verschiedenartig profiliert sein, beispielsweise im Wesentlichen U-förmig. Weiterhin kann vorteilhaft vorgesehen sein, dass die Ausnehmung eine insbesondere in sich geschlossen umlaufende Auskehlung aufweist.

Eine Ausnehmung in Form einer Auskehlung weist den Vorteil auf, dass an der Messelektrode eine Ausnehmung gebildet ist, welche sich in eine Wandung der Messelektrode hinein erstreckt. Die Auskehlung kann insbesondere in sich geschlossen an der Messelektrode umlaufend ausgebildet sein. Dadurch ist in einfacher Weise eine Möglichkeit gegeben, beispielsweise Wicklungen mit mehreren Windungen durch die Auskehlung verlaufen zu lassen. Die Auskehlung kann beispielsweise in Form einer Nut in die Messelektrode eingeformt werden. Entsprechend kann innerhalb der nutförmigen Auskehlung ein feldfreier Raum gebildet sein, welcher durch den Boden und die Wangen der Auskehlung dielektrisch geschirmt ist. Dazu kann die Messelektrode aus elektrisch leitfähigem Material geformt sein. Alternativ kann auch eine elektrisch leitende Beschichtung an der Messelektrode vorgesehen sein, um eine dielektrische Schirmung zu gewährleisten und einen kapazitiven Belag auszubilden. Es ist vorteilhaft, die Auskehlung möglichst vollständig mit der Sonde zu befüllen, so dass möglichst große Abschnitte, insbesondere die gesamte Sonde, innerhalb des in der Auskehlung gebildeten Feldschattens angeordnet ist. Die Auskehlung kann entsprechend gestaltete Profilierungen aufweisen, um ein einfaches, insbesondere formkomplementäres Befüllen der Auskehlung mit der Sonde zu erreichen. Bei einer außenmantelseitigen Anordnung der Auskehlung an einer ringförmig ausgebildeten Messelektrode ergibt sich so eine Ausnehmung, welche aus allen radialen Richtungen in Richtung des Ringzentrums zugänglich ist und so ein Befüllen bzw. ein Wickeln beispielsweise einer Wicklung der Sonde an der Messelektrode ermöglicht.

Eine weitere vorteilhafte Ausgestaltung kann vorsehen, dass die ringförmige Messelektrode eine im Wesentlichen U-förmige Profilierung aufweist.

Eine ringförmige Messelektrode mit im Wesentlichen U-förmigen Profil weist den Vorteil auf, dass die Wandung im Profilverlauf nahezu eine gleichbleibende Wandstärke aufweist. Damit kann zum einen eine massearme Messelektrode gebildet werden. Zum anderen kann durch die U-förmige Profilierung die Winkelsteifheit der Messelektrode verstärkt werden. Somit ergibt sich eine insbesondere ringförmige Messelektrode, welche nach Art einer Felge ausgeformt ist, wobei ein Felgenbett als in Form einer Auskehlung ausgeführte Ausnehmung dient und Felgenhörner (Nutwangen/Kehlwangen) das U-förmige Profil abschließen. Die Wandstärke der Messelektrode sollte im Verlauf der U-förmigen Profilierung annähernd konstant bleiben, wobei die Profilierung auch derart vorgenommen werden kann, dass beispielsweise zu den freien Enden des Profils der Messelektrode hin eine reduzierte Wandstärke vorgesehen ist. Das Profil kann beispielsweise im Wesentlichen kreisringförmig ausgebildet sein. Es können jedoch auch elliptische Querschnittsformen Verwendung finden.

Weiterhin ist vorteilhaft vorgesehen, dass die Messelektrode und die Sonde in einem Isolierkörper eingebettet sind.

Eine Einbettung von Messelektrode und Sonde in einen Isolierkörper ermöglicht es, Sonde und Messelektrode relativ zueinander zu fixieren. Insbesondere bei einem Tragen der Sonde durch die Messelektrode ist bereits vor einem Einbetten von Messelektrode und Sonde in einen Isolierkörper die Lage von Sonde und Messelektrode zueinander fixiert. Ein Einbetten in einen Isolierkörper sichert die Lage von Messelektrode und Sonde zueinander. Es kann beispielsweise vorgesehen sein, dass vor einer Einbettung der Messelektrode in deren Aufnahme bereits die Sonde des Stromsensors eingelegt sein kann und anschließend von einem flüssigen Isolierstoff umschlossen und eingeschlossen wird, so dass nach einem Aushärten ein fester Isolierkörper gegeben ist, welcher Messsonde und Messelektrode unverlierbar zusammenhält. Der Isolierkörper kann so ein Verkleben und Vernetzen (stoffschlüssiger Verbund) von Sonde und Messelektrode vornehmen.

Weiterhin kann vorteilhaft vorgesehen sein, dass an der ringförmigen Messelektrode eine im Wesentlichen radial ausgerichtete Anschlussfahne angeordnet ist.

Um die Messelektrode zu kontaktieren bzw. deren Potential abgreifen zu können ist es vorteilhaft, an der Messelektrode eine Anschlussfahne vorzusehen. Insbesondere bei der Verwendung einer ringförmigen Messelektrode sollte sich die Anschlussfahne in radialer Richtung von dem Ring bzw. dem Ringsegment forterstrecken. Beispielsweise kann die Messelektrode am äußeren Umfang an einer freien Fläche der Messelektrode angesetzt sein. Zum Beispiel kann bei einer U-förmig profilierten Messelektrode die Anschlussfahne an einem Schenkel des U-Profils angesetzt sein und frei von dem Schenkel fortragen. Bei einer ringförmigen Elektrode sollte die Anschlussfahne dabei radial ausgerichtet sein. Die Anschlussfahne führt dasselbe elektrische Potential wie die Elektrodenfläche der Messelektrode. Die Elektrodenfläche kann über die Anschlussfahne kontaktiert werden.

Vorteilhafterweise kann weiter vorgesehen sein, dass die Anschlussfahne auf eine in dem Isolierkörper angeordnete Kavität ausgerichtet ist.

Die Anschlussfahne ist beispielsweise ein elektrisch leitender Körper, welcher das Potential der Messelektrode führt, und welche ihrerseits kontaktiert werden kann, um das Potential der Messelektrode fortleiten zu können. Die Anschlussfahne kann in einer Kavität münden bzw. in eine Kavität hineinragen. Die Anschlussfahne kann dazu auf eine Kavität ausgerichtet sein, in welcher beispielsweise ein Steckanschluss, ein Schraubanschluss, eine Kontaktklemme, eine Anschlussleitung usw. angeordnet ist, um das Potential der Anschlussfahne beispielsweise über Anschlussleitungen fortleiten zu können. Neben einem elektrischen Kontaktieren der Messelektrode über die Anschlussfahne, kann die Anschlussfahne auch eine Verdrehsicherung in einem die Messelektrode aufnehmenden Isolierkörper darstellen. Beispielsweise ist so ein Verdrehen, Verschieben, Verkanten der Messelektrode innerhalb des Isolierkörpers verhindert. Die Kavität kann innerhalb des Isolierkörpers genutzt werden, um Anschlusselemente, wie Kabelsteckverbinder, Klemmkästen, Lötfahnen usw. aufzunehmen. Somit kann aus dem Isolierkörper heraus bereits mit Anschlussleitungen ein elektrisches Signal von der Messelektrode respektive von der Sonde, deren Anschlussleitungen beispielsweise auch in der Kavität münden können, abgegriffen und über Übertragungsstrecken fortgeleitet werden.

Eine weitere vorteilhafte Ausgestaltung kann vorsehen, dass die Kavität von einer Armatur umgriffen ist.

Eine Armatur kann beispielsweise ein Formkörper sein, welcher während eines Gießens des Isolierkörpers in den Isolierkörper eingegossen bzw. umgossen wird, so dass der Formkörper nach Art einer verlorenen Schaltung innerhalb des Isolierkörpers eine Kavität begrenzt. Die Armatur kann beispielsweise aus elektrisch leitfähigen Materialien, beispielsweise einem Aluminiumguss oder elektrisch isolierenden Materialien, beispielsweise einem Polyethylen, ausgestaltet sein. Die Verwendung eines elektrisch leitfähigen Materials weist den Vorteil auf, dass die Kavität dielektrisch geschirmt ist. Über die Armatur kann eine mechanische Verbindung zu weiteren Baugruppen hergestellt werden.

Eine weitere vorteilhafte Ausgestaltung kann vorsehen, dass ein die ringförmige Messelektrode durchsetzender Phasenleiter von einer Schirmelektrode umgriffen ist.

Eine Messelektrode dient dem Überwachen eines Zustandes eines Phasenleiters hinsichtlich seiner elektrischen Spannung. Eine ringförmige Messelektrode kann dabei den Phasenleiter umgreifen und von dem Phasenleiter durchsetzt sein. Im Bereich des Umgriffes des Phasenleiters durch die Messelektrode kann die Verwendung einer Schirmelektrode vorgesehen sein, die ihrerseits den Phasenleiter umgreift und wiederum von der Messelektrode umgriffen ist. Somit kann ein definierter Raum zwischen der Schirmelektrode und der Messelektrode gebildet werden, in welchem sich unabhängig von der Formgebung des Phasenleiters zwischen Schirmelektrode und Messelektrode ein elektrisches Feld ausbreitet. So ist es beispielsweise möglich, das elektrische Potential des Phasenleiters auf die Schirmelektrode zu übertragen, wobei das zwischen der Schirmelektrode und der Messelektrode angeordnete Dielektrikum in einem geometrisch vorgegebenen Rahmen definiert mit einem elektrischen Feld beaufschlagt wird, wodurch die Messelektrode ein bestimmtes elektrisches Potential annimmt. Entsprechend kann die Messgenauigkeit des die Messelektrode aufweisenden Spannungssensors verbessert werden. Zwischen Schirmelektrode und Messelektrode ist beispielsweise ein Zylinderkondensator ausgeformt. Die Schirmelektrode kann beispielsweise fluiddicht mit dem Phasenleiter verbunden werden. Beispielsweise können Schirmelektrode und Phasenleiter miteinander verschweißt sein. Alternativ können Schirmelektrode und Phasenleiter einstückig miteinander verbunden sein.

Eine weitere vorteilhafte Ausgestaltung kann vorsehen, dass die Schirmelektrode und/oder der Phasenleiter den Isolierkörper fluiddicht durchsetzen.

Der Phasenleiter, welcher in den Isolierkörper eingebettet ist, durchsetzt den Isolierkörper, so dass der Phasenleiter beiderseits des Isolierkörpers elektrisch kontaktierbar ist. Vorteilhafterweise sollte die Messelektrode vollständig mantel- sowie stirnseitig von Isolierstoff des Isolierkörpers umgeben sein, so dass eine mechanische Störung bzw. Einflussnahme auf die Messelektrode bzw. die Sonde durch den Isolierkörper verhindert ist. Entsprechend kann der Phasenleiter fluiddicht in den Isolierkörper eingesetzt sein. Beispielsweise kann der Phasenleiter fluiddicht mit dem Isolierwerkstoff umgossen sein.

Darüber hinaus kann auch vorgesehen sein, dass die Schirmelektrode selbst fluiddicht in den Isolierkörper eingesetzt ist, so dass der Isolierkörper auch in der Lage ist, mit einem den Isolierkörper durchsetzenden Phasenleiter eine fluiddichte Barriere auszubilden. Insbesondere ist es vorteilhaft, wenn sowohl der Phasenleiter als auch die Schirmelektrode fluiddicht miteinander verbunden sind, so dass ein fluiddichter Verbund aus Schirmelektrode, Isolierkörper und Phasenleiter gegeben ist.

Weiterhin kann vorteilhaft vorgesehen sein, dass mehrere Messelektroden und mehrere Sonden in einem Isolierkörper eingebettet sind.

Neben einer Ausgestaltung einer koaxialen Anordnung, an welcher zentrisch ein Phasenleiter angeordnet ist, welcher koaxial von einer Messelektrode und von einem Isolierkörper umgeben ist, kann weiterhin auch die Anordnung mehrerer Phasenleiter in ein und demselben Isolierkörper vorgesehen sein, wobei jedem der Phasenleiter jeweils eine Messelektrode, insbesondere auch jeweils eine Sonde zugeordnet ist. Somit ist es möglich, über einen gemeinsamen Isolierkörper mehrere Phasenleiter zu positionieren und bei der Positionierung der mehreren Phasenleiter zueinander auch eine elektrische Überwachung jedes einzelnen der Phasenleiter vornehmen zu können. Der Isolierkörper kann dazu einstückig oder mehrstückig ausgebildet sein. Beispielsweise kann eine Messelektrode mit einem Phasenleiter und einer Sonde vergossen sein und diese Halbfertigbaugruppe ist dann in einem weiteren Gussverfahren mit weiteren vorzugsweise gleichartigen Halbfertigbaugruppen zu einem gemeinsamen Isolierkörper miteinander vergossen, so dass der resultierende Isolierkörper aus mehreren Teilen zusammengesetzt ist, die fluiddicht miteinander verbunden sind. Entsprechend ergibt sich ein scheibenförmiger Isolierkörper, in welchem mehrere Messelektroden eingebettet sind und welcher von mehreren Phasenleitern fluiddicht durchsetzt ist.

Eine weitere vorteilhafte Ausgestaltung kann vorsehen, dass der Isolierkörper mantelseitig von einem Versteifungsrahmen umgeben ist.

Ein Versteifungsrahmen umgibt den Isolierkörper außenmantelseitig, so dass der Isolierkörper mechanisch geschützt ist. Der Versteifungsrahmen kann beispielsweise in sich geschlossen umlaufen. Insbesondere sollte der Versteifungsrahmen von Kanten und Ecken freigehalten werden. Insbesondere eignet sich ein im Wesentlichen ringförmiger Versteifungsrahmen, welcher in seinem Inneren einen im Wesentlichen kreiszylindrischen Isolierkörper aufnimmt. Über den Versteifungsrahmen ist es möglich, den Isolierkörper nebst darin befindlichen Messelektrode(n) bzw. Sonde(n) zu positionieren, zu transportieren, zu montieren usw.

Eine weitere vorteilhafte Ausgestaltung sieht vor, dass der Isolierkörper ein Stützisolator der/des Phasenleiter(s) ist.

Der Isolierkörper weist neben seinen elektrisch isolierenden Eigenschaften auch mechanische Eigenschaften auf, so dass eine ortsfeste Positionierung eines Phasenleiters über den Isolierkörper selbst vorgenommen werden kann. Insbesondere bei der Nutzung eines Versteifungsrahmens ist es möglich, die Messwandleranordnung beispielsweise an einem Flansch anzuflanschen und gegenüber dem Flansch eine Positionierung der Phasenleiter/des Phasenleiters vorzunehmen. Somit ist/sind der Phasenleiter/die Phasenleiter örtlich festgelegt. Über den Isolierkörper ist eine elektrische Isolation jedes Phasenleiters gewährleistet.

Eine weitere vorteilhafte Ausgestaltung kann vorsehen, dass der Isolierkörper Teil einer fluiddichten Barriere eines Kapselungsgehäuses ist.

Eine Messwandleranordnung kann vorteilhafterweise an einer Elektroenergieübertragungseinrichtung angeordnet sein. Eine Elektroenergieübertragungseinrichtung weist eine Reihe von Phasenleitern auf, die getrieben von einer elektrischen Spannung einen elektrischen Strom führen. Zur Isolation der Phasenleiter kann die Verwendung eines elektrisch isolierenden Fluids, insbesondere eines elektrisch isolierenden Gases, vorgesehen sein. Um ein Verflüchtigen des elektrisch isolierenden Fluids zu verhindern, kann das elektrisch isolierende Fluid in einem Kapselungsgehäuse eingeschlossen sein. Innerhalb dieses Kapselungsgehäuses kann das elektrisch isolierende Fluid unter einen Überdruck gesetzt werden, so dass sich die Durchschlagfestigkeit des elektrisch isolierenden Fluids zusätzlich erhöht. Als elektrisch isolierende Fluide sind beispielsweise Isolieröle oder Isoliergase, wie Schwefelhexafluorid, Stickstoff oder Gemische mit diesen Gasen einsetzbar. Die Phasenleiter sind vorzugsweise beabstandet zu den Kapselungsgehäusen zu führen bzw. durch die Kapselungsgehäuse elektrisch isoliert hindurchzuführen. Der Isolierkörper kann entsprechend als Teil einer Barriere an einem Kapselungsgehäuse eingesetzt werden, um einen Phasenleiter in ein mit einem elektrisch isolierenden Fluid befülltes Kapselungsgehäuse einzuführen. Das Kapselungsgehäuse kann beispielsweise als Druckbehälter ausgestaltet sein, so dass er einem Differenzdruck zwischen dem Inneren des Kapselungsgehäuses und der Umgebung des Kapselungsgehäuses widerstehen kann.

In Folgenden wird ein Ausführungsbeispiel der Erfindung schematisch in einer Zeichnung gezeigt und nachfolgend näher beschrieben.

Dabei zeigt die
- Figur 1: eine perspektivische Ansicht einer teilweise freigeschnittenen Messwandleranordnung, die
- Figur 2: einen Querschnitt durch die Messwandleranordnung im Ausschnitt und die
- Figur 3: einen Schnitt durch eine Messwandleranordnung im eingebauten Zustand.

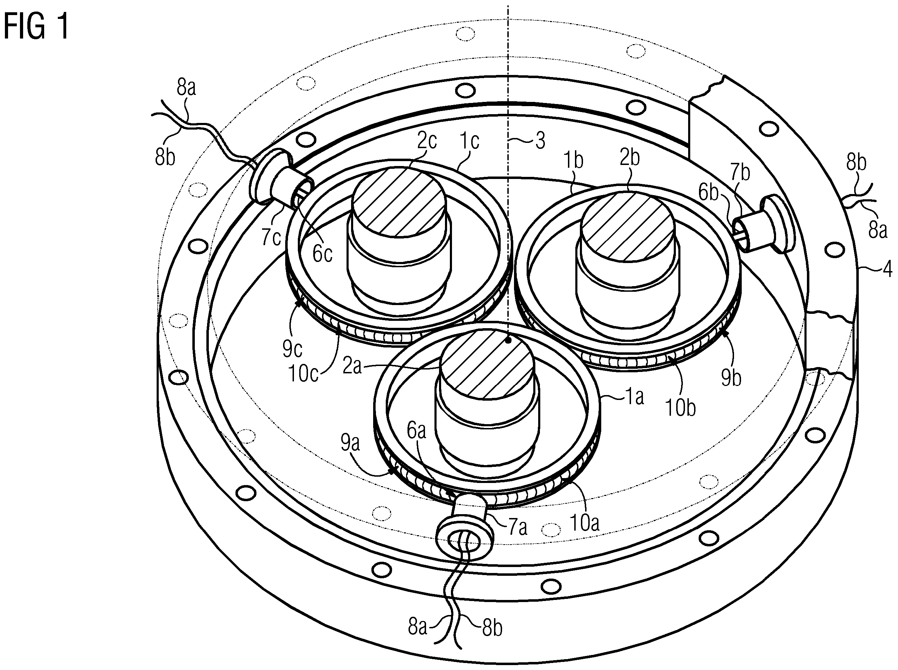

Die Figur 1 zeigt eine perspektivische Ansicht einer Messwandleranordnung. Die Messwandleranordnung ist vorliegend dreiphasig ausgebildet, d. h., die Messwandleranordnung weist einen Spannungssensor auf, der eine erste Elektrode, eine zweite Elektrode sowie eine dritte Elektrode 1a, 1b, 1c aufweist, welche einer Spannungsüberwachung eines ersten Phasenleiters 2a, eines zweiten Phasenleiters 2b, sowie eines dritten Phasenleiters 2c dient. Jeder der Phasenleiter 2a, 2b, 2c ist jeweils von einer der ringförmigen Messelektroden 1a, 1b, 1c umgriffen.

Die drei Phasenleiter 2a, 2b, 2c dienen der Übertragung jeweils eines elektrischen Stromes. Um einen elektrischen Strom durch jeden der drei Phasenleiter 2a, 2b, 2c zu treiben, sind die Phasenleiter 2a, 2b, 2c jeweils mit einer entsprechenden elektrischen Spannung beaufschlagt. Bei einer dreiphasigen Ausführungsvariante, wie in der Figur 1 gezeigt, ist vorzugsweise die Übertragung eines mehrphasigen Wechselspannungselektroenergiesystems vorgesehen, so dass drei Ströme durch die Phasenleiter 2a, 2b, 2c fließen, die bei Vorliegen von treibenden Wechselspannungen jeweils voneinander abweichende Momentanbeträge sowie verschiedenartige Phasenlagen aufweisen.

Abweichend von der in der Figur 1 gezeigten dreiphasigen Ausgestaltungsvariante kann die Erfindung jedoch auch in einer einphasigen Ausführung Verwendung finden. In diesem Falle ist statt der Verwendung dreier Phasenleiter 2a, 2b, 2c die Nutzung eines einzigen Phasenleiters vorgesehen, wobei die sich entsprechend zugehörigen Bauteile nur bezüglich des einzigen Phasenleiters vorhanden sind.

Die drei Phasenleiter 2a, 2b, 2c sind im Wesentlichen zylindrisch ausgestaltet, wobei die Phasenleiter 2a, 2b, 2c vorliegend einen kreisförmigen Querschnitt aufweisen. Die Zylinderachsen der Phasenleiter 2a, 2b, 2c sind annähernd parallel zueinander ausgerichtet, wobei in einer Draufsicht auf die Zylinderachsen der Phasenleiter 2a, 2b, 2c die Zylinderachsen beabstandet zueinander angeordnet sind und die Eckpunkte eines gleichseitigen Dreieckes definieren. Die Zylinderachsen liegen parallel zu einer Hauptachse 3, welche innerhalb des zwischen den Phasenleitern 2a, 2b, 2c gebildeten Dreieckes liegt.

Die drei Phasenleiter 2a, 2b, 2c sind in einem Isolierkörper 12 eingebettet. In der Figur 1 ist der Isolierkörper 12 nicht dargestellt. Der Isolierkörper 12 ist scheibenartig ausgeformt und außenmantelseitig von einem Versteifungsrahmen 4 umgeben. Der Versteifungsrahmen 4 ist vorliegend kreisringförmig ausgebildet, wobei der Versteifungsrahmen 4 koaxial zur Hauptachse 3 ausgerichtet ist. In der Figur 1 wurde der Isolierkörper 12 freigeschnitten, so dass der innere Aufbau, der innerhalb des Isolierkörpers 12 eingebetteten Baugruppen erkennbar ist. Die drei Phasenleiter 2a, 2b, 2c durchsetzen den Isolierkörper 12 derart, dass Stirnseiten des Isolierkörpers 12 von den Phasenleitern 2a, 2b, 2c durchstoßen und überragt sind. Somit ist es möglich, beiderseits der Stirnseiten des Isolierkörpers 12 eine elektrische Kontaktierung der Phasenleiter 2a, 2b, 2c vorzunehmen. Die Phasenleiter 2a, 2b, 2c sollten möglichst fluiddicht in den Isolierkörper 12 eingesetzt sein. Zu einer vereinfachten Einbindung der Phasenleiter 2a, 2b, 2c weist der Isolierkörper 12 Öffnungen auf, welche von den Phasenleitern 2a, 2b, 2c durchsetzt sind. Um eine verbesserte Funktion der Messwandleranordnung zu ermöglichen, sind die Phasenleiter 2a, 2b, 2c jeweils von Schirmelektroden 5a, 5b, 5c umgeben. Die Schirmelektroden 5a, 5b, 5c führen jeweils das elektrische Potential des zugeordneten ersten Phasenleiters 2a, zweiten Phasenleiters 2b oder dritten Phasenleiters 2c. Die Schirmelektroden 5a, 5b, 5c sind elektrisch leitend mit den jeweiligen Phasenleitern 2a, 2b, 2c verbunden. Die Schirmelektroden 5a, 5b, 5c umgreifen den jeweiligen Phasenleiter 2a, 2b, 2c jeweils außenmantelseitig. Die Schirmelektroden 5a, 5b, 5c sind jeweils hohlzylindrisch ausgestaltet, wobei die Stirnseiten aus Gründen einer dielektrisch günstigen Kontur abgerundet sind. Die Phasenleiter 2a, 2b, 2c, sind vorzugsweise fluiddicht mit den jeweils zugehörigen Schirmelektroden 5a, 5b, 5c verbunden, wobei die Schirmelektroden 5a, 5b, 5c jeweils fluiddicht mit dem Isolierkörper 12 verbunden sind. Somit ist es möglich, eine fluiddichte Barriere zwischen den Phasenleitern 2a, 2b, 2c, den Schirmelektroden 5a, 5b, 5c sowie dem Isolierkörper 12 auszubilden. Neben einer Ausgestaltung der Schirmelektrode 5a, 5b, 5c als diskrete Bauteile kann eine entsprechende Formgebung der Phasenleiter 2a, 2b, 2c in einstückiger Form vorgesehen sein.

Jeder der Phasenleiter 2a, 2b, 2c ist von jeweils einer Messelektrode 1a, 1b, 1c außenmantelseitig umgriffen. Die Messelektroden 1a, 1b, 1c sind dabei ringförmig ausgeformt und sind koaxial zu dem jeweiligen Phasenleiter 2a, 2b, 2c angeordnet. Die Lage der Schirmelektroden 5a, 5b, 5c zu den Messelektroden 1a, 1b, 1c ist dabei derart gewählt, dass die Schirmelektroden 5a, 5b, 5c in Richtung der Hauptachse 3 bzw. der Zylinderachsen eine größere räumliche Ausdehnung aufweist, als die jeweils zugeordnete Messelektrode 1a, 1b, 1c. Die jeweilige Messelektrode 1a, 1b, 1c ist innenmantelseitig der jeweiligen Schirmelektrode 5a, 5b, 5c zugewandt. Die Schirmelektroden 5a, 5b, 5c führen jeweils das elektrische Potential des jeweils zugeordneten Phasenleiters 2a, 2b, 2c. Die Messelektroden 1a, 1b, 1c sind elektrisch isoliert zu dem jeweils umgriffenen Phasenleiter 2a, 2b, 2c sowie zu den weiteren Phasenleitern 2a, 2b, 2c angeordnet. Ebenso sind die Messelektroden 1a, 1b, 1c untereinander elektrisch isoliert angeordnet. Um die Messelektroden 1a, 1b, 1c und die Phasenleiter 2a, 2b, 2c zueinander räumlich festzulegen, sind diese Baugruppen in dem Isolierkörper 12 eingebettet. Der Isolierkörper 12 selbst ist im Wesentlichen scheibenförmig ausgeführt und außenmantelseitig von dem Versteifungsrahmen 4 umgeben. Der Isolierkörper 12 kann beispielsweise einstückig ausgeführt sein. Es kann jedoch auch vorgesehen sein, dass der Isolierkörper 12 mehrstückig gebildet ist, so dass beispielsweise eine Halbfertigbaugruppe ein erstes Teil des Isolierkörpers 12 aufweist, wobei ein oder mehrere weitere Teile des Isolierkörpers 12 das erste Teil zu einem scheibenförmigen Isolierkörper 12 ergänzen.

Die Messelektroden 1a, 1b, 1c weisen an ihrem äußeren Umfang jeweils eine Anschlussfahne 6a, 6b, 6c auf. Eine Anschlussfahne 6a, 6b, 6c führt das elektrische Potential der sie jeweils tragenden Messelektrode 1a, 1b, 1c. Eine Messelektrode 1a, 1b, 1c kann beispielsweise aus einem elektrisch leitfähigen Material, beispielsweise Kupfer, Aluminium, elektrisch leitfähiger Kunststoff usw. gefertigt sein. Mittels der Anschlussfahne 6a, 6b, 6c ist das Potential der jeweiligen Messelektrode 1a, 1b, 1c in eine Kavität innerhalb des Isolierkörpers 12 übertragbar. Vorliegend ist jedem Phasenleiter 2a, 2b, 2c eine Kavität zugeordnet. Die Kavitäten innerhalb des Isolierkörpers 12 sind jeweils von einer Armatur 7a, 7b, 7c umgriffen. Die Armaturen 7a, 7b, 7c umschließen jeweils eine Kavität, welche sich fluchtend an die radial ausgerichtete Anschlussfahnen 6a, 6b, 6c der jeweiligen Messelektrode 1a, 1b, 1c anschließen. Innerhalb der von den Armaturen 7a, 7b, 7c umgriffenen Kavitäten ist eine Führung von Messleitungen 8a, 8b möglich, um beispielsweise die jeweilige Messelektrode 1a, 1b, 1c zu kontaktieren. Die Armaturen 7a, 7b, 7c sind stoffschlüssig in den scheibenförmigen Isolierkörper 12 eingefügt und umgreifen die Kavitäten, welche in radialer Richtung zu einer Mantelfläche am äußeren Umfang des Isolierkörpers 12 führen. Dort ist innerhalb des Versteifungsrahmens 4 fluchtend jeweils eine radial ausgerichtete Ausnehmung vorgesehen, durch welche Anschlussleitungen 8a, 8b nach außen geführt werden können.

Die Messelektroden 1a, 1b, 1c sind jeweils gleichartig ausgeführt. Die Messelektroden 1a, 1b, 1c sind ringförmig ausgeführt, wobei Material und Dimensionierung derart gewählt sind, dass die Messelektroden 1a, 1b, 1c selbst verwindungssteif ausgeführt ist. Die Messelektroden 1a, 1b, 1c sind außenmantelseitig jeweils mit einer Aufnahme in Form einer Ausnehmung 9a, 9b, 9c versehen. Die Ausnehmungen 9a, 9b, 9c sind vorliegend nach Art einer in sich geschlossenen umlaufenden Auskehlung in die Messelektroden 1a, 1b, 1c eingebracht. Die Auskehlung weist dabei ein bogenförmiges Profil, beispielsweise als Kreissegment oder als Ellipsensegment auf. Vorzugsweise kann das Profil der Messelektroden 1a, 1b, 1c U-förmig gewählt werden, wobei das Profil mit gerundeten Ecken ausgestaltet sein sollte. Durch die Ausnehmung 9a, 9b, 9c ist in einer Außenmantelfläche der Messelektroden 1a, 1b, 1c eine umlaufende Nut gebildet. Bei einer entsprechenden Profilierung mit einem U-förmigen, z. B. halbkreisförmigen oder ellipsoidringförmigen Profil ist so eine Messelektrode 1a, 1b, 1c nach Art einer Felge entstanden, wobei die Ausnehmung 9a, 9b, 9c zwischen Felgenhörnern ausgeformt ist. Vorzugsweise kann die Messelektrode 1a, 1b, 1c beispielsweise eine annähernd gleichmäßige Wandstärke im Profil aufweisen. Die Ausnehmungen 9a, 9b, 9c sind zumindest teilweise durch die kapazitiven Beläge/die Elektrodenflächen der Messelektroden 1a, 1b, 1c dielektrisch geschirmt.

Durch die Ausnehmungen 9a, 9b, 9c sind Aufnahmen gebildet, in welche jeweils eine Sonde 10a, 10b, 10c eines Stromsensors einlegbar ist. Die Sonden 10a, 10b, 10c können beispielsweise jeweils eine Halbleitergruppe aufweisen, welche jeweils im Feldschatten der in den Ausnehmungen 9a, 9b, 9c dielektrisch geschirmten Bereiche der Messelektroden 1a, 1b, 1c eingelegt sind. Derartige Sonden 10a, 10b, 10c können beispielsweise Hallsonden umfassen. Des Weiteren können die Ausnehmungen 9a, 9b, 9c auch zur Aufnahme von jeweils einer Wicklung dienen. Eine Wicklung kann beispielsweise eine optische Faser aufweisen, welche zumindest ein- insbesondere mehrfach die Ausnehmung 9a, 9b, 9c umlaufend, mehrere Schlingen ausbildend, an der jeweiligen Messelektrode 1a, 1b, 1c positioniert ist. Somit ist es möglich, ein polarisiertes Licht in den Bereich des jeweils umgriffenen Phasenleiters 1a, 1b, 1c zu lenken, wobei die Polarisationsebene des polarisierten Lichtes in Abhängigkeit eines auftretenden Magnetfeldes des den jeweiligen Phasenleiter 1a, 1b, 1c durchfließenden Stromes abgelenkt wird. Darüber hinaus kann die Sonde auch eine transformatorische Wicklung aufweisen, welche den jeweiligen Phasenleiter 1a, 1b, 1c in der jeweiligen Ausnehmung 9a, 9b, 9c liegend umgreift. Eine besonders vorteilhafte Ausgestaltung kann dabei vorsehen, dass die Sonden 10a, 10b, 10c jeweils eine Rogowskispule aufweisen, wobei die Rogowskispulen jeweils gegengleich zur Formgebung der Ausnehmungen 9a, 9b, 9c ausgeformt sind, so dass die Rogowskispulen bündig in die Ausnehmungen 9a, 9b, 9c eingelegt werden können. Die Rogowskispulen befinden sich so im dielektrischen Feldschatten der jeweiligen Messelektrode 1a, 1b, 1c. Eine Rogowskispule kann dabei vollständig innerhalb des Feldschattens der jeweiligen Ausnehmung 9a, 9b, 9c angeordnet sein. Es kann jedoch auch vorgesehen sein, dass lediglich Teile der in der jeweiligen Ausnehmung 9a, 9b, 9c befindlichen Rogowskispulen dielektrisch geschirmt sind. So kann beispielsweise in der sich außenmantelseitig öffnenden Ausnehmung 9a, 9b, 9c eine Rogowskispule aus der Ausnehmung 9a, 9b, 9c herausragen. Beispielsweise kann eine Rogowskispule im Querschnitt kreisförmig ausgeführt sein, wobei diese kreisförmige Ausgestaltung formkomplementär in die Querschnittsgestaltung der zugehörigen Ausnehmung 9a, 9b, 9c eingreift. Eine Kontaktierung der Wicklungen, insbesondere der Rogowskispulen, der Sonden 10a, 10b, 10c kann über die Kavitäten, welche innerhalb der Armaturen 7a, 7b, 7c in dem Isolierkörper 12 angeordnet sind, vorgesehen sein. Entsprechend können Anschlussleitungen 8a, 8b von den Sonden 10a, 10b, 10c des Stromsensors aus dem Inneren des Isolierkörpers 12 herausgeführt werden.

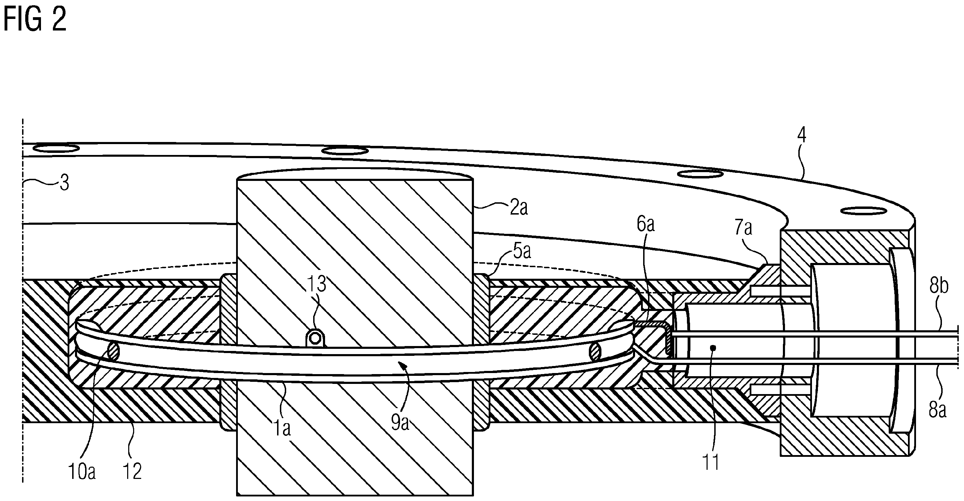

In der Figur 2 ist beispielhaft die erste Messelektrode 1a sowie der erste Phasenleiter 2a sowie die weiteren unmittelbar dem ersten Phasenleiter 2a bzw. der ersten Messelektrode 1a zugeordneten Baugruppen im Schnitt gezeigt. Die zweite Messelektrode 1b sowie die dritte Messelektrode 1c ebenso wie der zweite Phasenleiter 2b sowie der dritte Phasenleiter 2c sowie die weiteren diesen weiteren Messelektroden 1b, 1c, bzw. weiteren Phasenleitern 2b, 2c zugeordneten Baugruppen sind gleichartig zu der in der Figur 2 beispielhaft gezeigten Konstruktion ausgeformt.

Die Figur 2 zeigt einen Schnitt, in dessen Schnittebene die Hauptachse 3 liegt. Entsprechen ist der Versteifungsrahmen 4 im Profil geschnitten erkennbar. Der erste Phasenleiter 2a ist ebenfalls geschnitten. Zu erkennen ist die außenmantelseitige Umgreifung des ersten Phasenleiters 2a von der zugehörigen Schirmelektrode 5a. Die zugehörige Schirmelektrode 5a ist ihrerseits außenmantelseitig von der zugehörigen ersten Messelektrode 1a umgriffen. Die erste Messelektrode 1a tritt aus der Schnittebene heraus und lässt die in sich geschlossene ringförmige Struktur der ersten Messelektrode 1a erkennen. Die erste Messelektrode 1a weist im Profil eine U-förmige Formgebung auf, welche im Wesentlichen halbkreisringförmig ausgestaltet ist. Die gebildete Ausnehmung 9a ist mit einer die Messelektrode 1a außenmantelseitig umgreifenden Sonde 10a befüllt. Die Sonde 10a weist einen im Wesentlichen kreisförmigen Querschnitt auf, welcher gegengleich zur Profilierung der Ausnehmung 9a ausgeführt ist. Die Sonde 10a läuft außenmantelseitig um die erste Messelektrode 1a um.

An einem der im Profil gebildeten, die Ausnehmung begrenzenden Schenkel der ersten Messelektrode 1a ist beispielhaft die Position einer Anschlussfahne 6a dargestellt, welche in radialer Richtung, bezogen auf die zentrisch liegende Rotationsachse der Messelektrode 1a in radialer Richtung in Richtung einer Innenmantelfläche des Versteifungsrahmens 4 ragt. Die Anschlussfahne 6a ragt bis an einen Boden einer Kavität 11 des Isolierkörpers 12 heran. Die Kavität 11 ist von einer Armatur 7a, welche sich zumindest teilweise bis in den Isolierkörper 12 hinein erstreckt, begrenzt. Die Armatur 7a ist im Wesentlichen rotationssymmetrisch hohlzylindrisch ausgeführt und an ihrem dem Versteifungsrahmen 4 zugewandten Ende mit dem Versteifungsrahmen 4 winkelstarr, beispielsweise mittels einer Verschraubung, verbunden. Im Bereich der Verbindung von der Armatur 7a mit dem Versteifungsrahmen 4 ist in dem Versteifungsrahmen eine Ausnehmung angebracht, um außenmantelseitig von dem Versteifungsrahmen 4 ausgehend in die Kavität 11 hinein Anschlussleitungen 8a, 8b einzuführen. Eine Anschlussleitung 8a kann zum einen an die Sonde 10a des ersten Phasenleiters 2a des Stromsensors angeschlossen werden. Zum anderen kann die erste Messelektrode 1a über eine Anschlussleitung 8b kontaktiert werden. Dazu ist die Anschlussleitung 8b mit der Anschlussfahne 6a verbunden. Die Anschlussfahne 6a ist an der Messelektrode 1a in dem Bereich angeordnet, an welchem die Messelektrode 1a den geringsten Abstand zu der Innenmantelfläche des Versteifungsrahmens 4 aufweist.

Der Isolierkörper 12 ist in der Figur 2 beispielhaft aus mehreren Teilelementen zusammengesetzt. So ist gemäß der Ausgestaltung der Figur 2 vorgesehen, zunächst einen winkelstarren Verbund zwischen dem ersten Phasenleiter 2a, der zugehörigen Schirmelektrode 5a, sowie der den ersten Phasenleiter 2a umgreifenden ersten Messelektrode 1a auszubilden. Entsprechend ist ein im Wesentlichen kreisscheibenförmiger erstes Teil des Isolierkörpers 12 gebildet, in welchem die erste Messelektrode 1a eingebettet ist. Die erste Messelektrode 1a ist mit der zugehörigen Sonde 10a vollständig innerhalb des Isolierkörpers 12 eingebettet, insbesondere vollständig innerhalb des ersten Teiles des Isolierkörpers 12. Die erste Messelektrode 1a weist eine Haltelasche 13 auf, welche eine formschlüssige Festlegung innerhalb des Isolierkörpers 12 ermöglicht. Zur Herstellung einer Messwandleranordnung kann vorgesehen sein, dass der Isolierkörper 12 zunächst in flüssiger Form zur Einbettung der ersten Messelektrode 1a nebst Sonde 10a sowie des ersten Phasenleiters 2a und der zugehörigen Schirmelektrode 5a gegossen wird. Nach einem Aushärten des Isoliermaterials werden die halbfertigen Phasenleiter 2a, 2b, 2c innerhalb des Versteifungsrahmens 4 positioniert, woraufhin ein vollständiger Umguss mit weiterem Isoliermaterial erfolgt, so dass der Isolierkörper 12 mehrere unabhängig voneinander gegossene Teilelemente aufweist. Die Dimensionierung kann dabei derart gewählt werden, dass Teilelemente des Isolierkörpers 12 vollständig von einem abschließenden Umguss mit Isoliermaterial ummantelt sind. In jedem Falle sollten jedoch Stirnseiten der Phasenleiter 2a, 2b, 2c aus dem Isolierkörper 12 herausragen. Es kann vorgesehen sein, dass ebenso die Schirmelektroden 5a, 5b, 5c stirnseitig aus dem Isolierkörper 12 herausragen. Je nach Bedarf kann die Wandstärke des Isolierkörpers 12 variieren. Beispielsweise kann auch vorgesehen sein, dass der Isolierkörper 12 im Wesentlichen die selbe Wandstärke aufweist, wie der Versteifungsrahmen, so dass auch die Armaturen 7a, 7b, 7c vollständig von dem Isolierkörper 12 ummantelt sind, ebenso wie die Schirmelektroden 5a, 5b, 5c. Unabhängig von der Art der Fertigung des Isolierkörpers 12 sollten die Stirnseiten des Isolierkörpers 12 frei von Stoßfugen im Isoliermaterial sein.

Der Isolierkörper 12 kann auch einstückig ausgebildet werden, d. h., sämtliche von dem Isolierkörper 12 umgebenen Bauteile werden in einem einzigen Guss mit noch nicht ausgehärtetem Isoliermaterial ummantelt. Nach einem Aushärten ergibt sich ein winkelstarrer Isolierkörper 12, der die eingebetteten Bauteile ortsfest positioniert und seinerseits ortsfest innerhalb des Versteifungsrahmens 4 liegt.

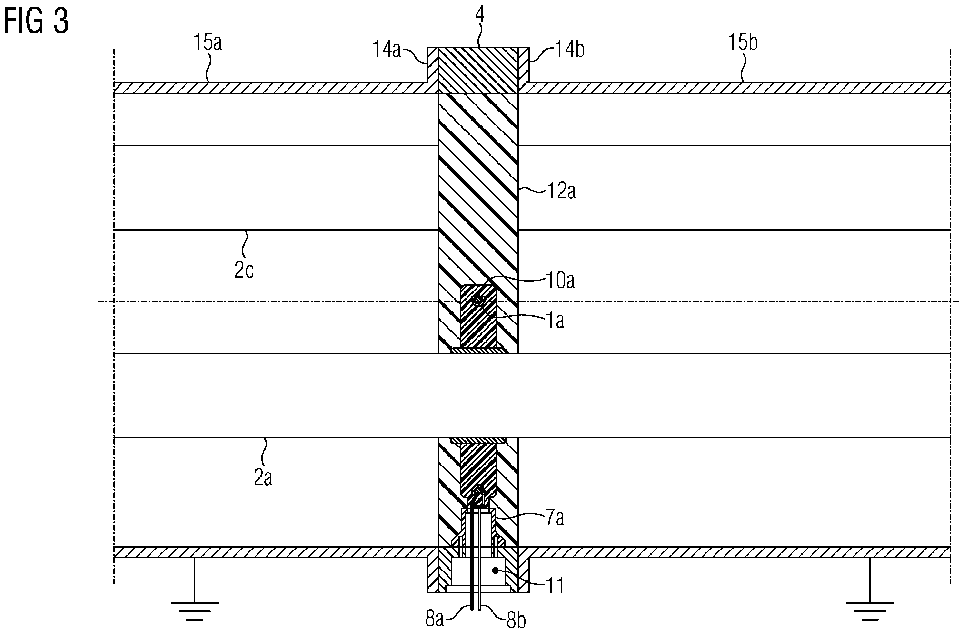

In der Figur 3 ist ein Schnitt durch eine Messwandleranordnung im eingebauten Zustand gezeigt. Der Versteifungsrahmen 4 ist zwischen einem ersten Ringflansch 14a sowie einem zweiten Ringflansch 14b angeordnet. Die beiden Ringflansche 14a, 14b sind unter Zwischenlage des Versteifungsrahmens 4 gegeneinander verbolzt. Die Bolzen können beispielsweise durch Ausnehmungen, welche in dem Versteifungsrahmen 4 angeordnet sind, hindurchragen, so dass ein kraftschlüssiger sowie formschlüssiger Verbund zwischen den Ringflanschen 14a, 14b sowie dem Versteifungsrahmen 4 gegeben ist. Beispielhaft ist in der Figur 3 eine Verwendung eines Isolierkörpers 12a gezeigt, welcher die annähernd selbe Breite aufweist wie der Versteifungsrahmen 4. Im Schnitt erkennt man symbolisch die den ersten Phasenleiter 2a umgreifende Schirmelektrode 5a, sowie die erste Messelektrode 1a, welche den ersten Phasenleiter 2a umgreift und welche ihrerseits in einer Ausnehmung 9a eine Sonde 10a des Stromsensors aufnimmt. Die Stärke des Isolierkörpers 12 ist dabei derart gewählt, dass bis auf die stirnseitig den Isolierkörper 12a überragenden Phasenleiter 2a, 2c weitere Elemente innerhalb des Isolierkörpers 12a befindlich angeordnet sind. Ein Zugang zu den im Innern des Isolierkörper 12a befindlichen Elementen ist über die in dem Isolierkörper 12a befindliche Kavität 11, welche ihrerseits in einer Ausnehmung des Versteifungsrahmens 4 mündet, ermöglicht. Über diesen Zugang sind Anschlussleitungen 8a, 8b für den Stromsensor sowie den Spannungssensor zugänglich.

Der erste sowie der zweite Ringflansch 14a, 14b sind mit einem ersten Kapselungsgehäuse 15a sowie einem zweiten Kapselungsgehäuse 15b verbunden. Die beiden Kapselungsgehäuse 15a, 15b sind im Wesentlichen rohrförmig ausgestaltet, wobei im Innern ein Aufnahmevolumen gegeben ist, in welchem die Phasenleiter 2a, 2c angeordnet sind. Die beiden Kapselungsgehäuse 15a, 15b sind fluiddicht ausgestaltet, so dass das Innere mit einem elektrisch isolierenden Fluid befüllt werden kann. Das elektrisch isolierenden Fluid kann dabei zur Erhöhung der Isolationsfestigkeit unter Überdruck gesetzt werden, so dass die Kapselungsgehäuse 15a, 15b Druckbehälter sind. Die Phasenleiter 2a, 2c sind elektrisch isoliert an den Kapselungsgehäusen 15a, 15b abgestützt. Eine elektrisch isolierte Halterung der Phasenleiter 2a, 2c erfolgt dabei über den Isolierkörper 12a der Messwandleranordnung. Somit ist es möglich, das erste und das zweite Kapselungsgehäuse 15a, 15b elektrisch leitfähig auszuführen und die Kapselungsgehäuse 15a, 15b beispielsweise mit Erdpotential zu beaufschlagen. Eine Isolationsstrecke innerhalb der Kapselungsgehäuse 15a, 15b zwischen den Phasenleitern 2a, 2c untereinander, sowie der Phasenleiter 2a, 2c gegenüber den Kapselungsgehäusen 15a, 15b ist durch das elektrisch isolierende Fluid gegeben. Vorliegend ist die Messwandleranordnung derart ausgeführt, dass über den Isolierkörper 12 eine fluiddichte Barriere zwischen den beiden Volumina von erstem und zweitem Kapselungsgehäuse 15a, 15b gegeben ist, d. h., ein Übertritt eines elektrisch isolierenden Fluides aus dem von dem ersten Kapselungsgehäuse 15a umschlossenen Bereich in den von dem zweiten Kapselungsgehäuse 15b umschlossenen Bereich ist durch die Messwandleranordnung 1a mit ihrem Isolierkörper 12a verhindert. Entsprechend stellt der Isolierkörper 12 einen Teil einer druckdichten Barriere, die fluiddicht ist, an einem Kapselungsgehäuse 15a, 15b dar. Entsprechend ist eine fluiddichte Einbettung und Hindurchführung der Phasenleiter 2a, 2c durch den Isolierkörper 12a vorgesehen. Es kann jedoch auch vorgesehen sein, das in dem Isolierkörper 12 bzw. an der Messwandleranordnung Überströmkanäle vorgesehen sind, über welche ein Isolierfluid von dem ersten in das zweite Kapselungsgehäuse 15a, 15b und umgekehrt überströmen kann.

Die Kapselungsgehäuse 15a, 15b sind beispielsweise Teil einer fluidisolierten Elektroenergieübertragungseinrichtung, die bei Nutzung eines elektrischen Isoliergases als "gasisoliert" bezeichnet wird. Mittels einer gasisolierten Elektroenergieübertragungseinrichtung kann ein elektrischer Strom durch Phasenleiter 2a, 2b, 2c getrieben werden, so dass eine Übertragung elektrischer Energie zwischen zwei Punkten ermöglicht ist.

Unter Nutzung der Messelektroden 9a, 9b, 9c ist eine Kapazitätsbelag zwischen dem jeweilig zugeordneten Phasenleiter 2a, 2b, 2c sowie der Umgebung der Phasenleiter 2a, 2b, 2c insbesondere gegenüber einem der Kapselungsgehäuse 15a, 15b bzw. gegenüber dem Versteifungsrahmen 4 gegeben. Somit ist ein kapazitiver Spannungsteiler vorzugsweise zwischen dem Potential des jeweiligen Phasenleiters 2a, 2b, 2c und zwischen dem Erdpotential gegeben. Entsprechend stellt sich eine Aufladung der elektrisch isoliert angeordneten Messelektroden 1a, 1b, 1c ein. Das Potential der Messelektroden 1a, 1b, 1c kann über eine Messleitung 8b aus der Messwandleranordnung herausgeleitet werden. Die Information über das Potential der Messelektrode 1a, 1b, 1c kann weiterverarbeitet werden und ein Rückschluss über das Potential des jeweiligen Phasenleiters 2a, 2b, 2c gezogen werden.

Unter Nutzung der Sonden 10a, 10b, 10c, welche jeweils in einer Ausnehmung 9a, 9b, 9c der jeweils zugeordneten Messelektrode 1a, 1b, 1c eingelegt sind, ist es beispielsweise möglich, unter Nutzung des transformatorischen Prinzips, einen elektrischen Stromfluss durch den jeweils zugehörigen Phasenleiter 2a, 2b, 2c abzubilden. Ein von der Sonde 10a, 10b abgegebenes Signal kann über eine Anschlussleitung 8, 8a forttransportiert werden. Die Informationen hinsichtlich eines überwachten elektrischen Stromes, welche durch den Stromsensor geliefert werden, sowie hinsichtlich einer überwachten elektrischen Spannung, welche durch den Spannungssensor geliefert wird, kann nunmehr weiter genutzt bzw. weiter verarbeitet werden.

## Patentansprüche

1. Messwandleranordnung zum Überwachen eines oder mehrerer Phasenleiter (2a, 2b, 2c), aufweisend einen Spannungssensor und einen Stromsensor, wobei der Spannungssensor eine Messelektrode (1a, 1b, 1c) zum Erfassen einer elektrischen Spannung aufweist, wobei die Messelektrode (1a, 1b, 1c) ringförmig ausgeformt ist und eine Aufnahme (9a, 9b, 9c) aufweist, in welcher eine Sonde (10a, 10b, 10c) des Stromsensors positioniert ist,
wobei die Aufnahme (9a, 9b, 9c) als Ausnehmung (9a, 9b, 9c) in der Messelektrode (1a, 1b, 1c) ausgeformt und außenmantelseitig an der Messelektrode (1a, 1b, 1c) angeordnet ist, **dadurch gekennzeichnet, dass** die Messelektrode (1a, 1b, 1c) und die Sonde (10a, 10b, 10c) in einem Isolierkörper (12, 12a,)eingebettet sind, welcher ein Stützisolator der/des Phasenleiter(s) (2a, 2b, 2c) ist.

2. Messwandleranordnung nach Anspruch 1,
**dadurch gekennzeichnet, dass** die Sonde (10a, 10b, 10c) zumindest teilweise durch die Messelektrode (1a, 1b, 1c) dielektrisch geschirmt ist.

3. Messwandleranordnung nach Anspruch 1 oder 2,
**dadurch gekennzeichnet, dass** die Ausnehmung (9a, 9b, 9c) eine insbesondere in sich geschlossen umlaufende Auskehlung aufweist.

4. Messwandleranordnung nach einem der Ansprüche 1 bis 3,
**dadurch gekennzeichnet, dass** die ringförmige Messelektrode (1a, 1b, 1c) eine im Wesentlichen U-förmige Profilierung aufweist.

5. Messwanderanordnung nach einem der Ansprüche 1 bis 4,
**dadurch gekennzeichnet, dass** an der ringförmigen Messelektrode (1a, 1b, 1c) eine im Wesentlichen radial ausgerichtete Anschlussfahne (6a, 6b, 6c) angeordnet ist.

6. Messwandleranordnung nach Anspruch 5,
**dadurch gekennzeichnet, dass** die Anschlussfahne (6a, 6b, 6c) auf eine in dem Isolierkörper (12, 12a) angeordnete Kavität (11) ausgerichtet ist.

7. Messwandleranordnung nach Anspruch 6,
**dadurch gekennzeichnet, dass** die Kavität (11) von einer Armatur (7a, 7b, 7c) umgriffen ist.

8. Messwandleranordnung nach einem der Ansprüche 1 bis 7,
**dadurch gekennzeichnet, dass** ein die ringförmige Messelektrode (1a, 1b, 1c) durchsetzender Phasenleiter (2a, 2b, 2c) von einer Schirmelektrode (5a, 5b, 5c) umgriffen ist.

9. Messwandleranordnung nach Anspruch 8,
**dadurch gekennzeichnet, dass** die Schirmelektrode (5a, 5b, 5c) und/oder der Phasenleiter (2a, 2b, 2c) den Isolierkörper (12, 12a) fluiddicht durchsetzt.

10. Messwandleranordnung nach einem der Ansprüche 1 bis 9,
**dadurch gekennzeichnet, dass** mehrere Messelektroden (1a, 1b, 1c) und mehrere Sonden (10a, 10b, 10c) in einem Isolierkörper (12, 12a) eingebettet sind.

11. Messwandleranordnung nach Anspruch 1 bis 10,
**dadurch gekennzeichnet, dass** der Isolierkörper (12, 12a) mantelseitig von einem Versteifungsrahmen (4) umgeben ist.

12. Messwandleranordnung nach einem der Ansprüche 1 bis 11,
**dadurch gekennzeichnet, dass** der Isolierkörper (12, 12a) Teil einer fluiddichten Barriere eines Kapselungsgehäuses (15a, 15b) ist.

13. Messwandleranordnung nach Anspruch 12,
**dadurch gekennzeichnet, dass** in dem Kapselungsgehäuse (15a, 15b) ein elektrisch isolierendes Fluid eingeschlossen ist.

## Claims

1. Instrument transformer arrangement for monitoring one or more phase conductors (2a, 2b, 2c), having a voltage sensor and a current sensor, wherein the voltage sensor has a measuring electrode (1a, 1b, 1c) for detecting a voltage, wherein the measuring electrode (1a, 1b, 1c) is in the form of a ring and has a receptacle (9a, 9b, 9c), in which a probe (10a, 10b, 10c) of the current sensor is positioned, wherein the receptacle (9a, 9b, 9c) is formed as a cutout (9a, 9b, 9c) in the measuring electrode (1a, 1b, 1c) and is arranged on the outer lateral surface side on the measuring electrode (1a, 1b, 1c), **characterized in that** the measuring electrode (1a, 1b, 1c) and the probe (10a, 10b, 10c) are embedded in an insulating body (12, 12a), which is a post insulator of the phase conductor(s) (2a, 2b, 2c).

2. Instrument transformer arrangement according to Claim 1, **characterized in that**
the probe (10a, 10b, 10c) is dielectrically shielded at least partially by the measuring electrode (1a, 1b, 1c).

3. Instrument transformer arrangement according to Claim 1 or 2,
**characterized in that**
the cutout (9a, 9b, 9c) has an in particular continuously peripheral groove.

4. Instrument transformer arrangement according to one of Claims 1 to 3,
**characterized in that**
the ring-shaped measuring electrode (1a, 1b, 1c) has a substantially U-shaped profile.

5. Instrument transformer arrangement according to one of Claims 1 to 4,
**characterized in that**
a substantially radially aligned connecting lug (6a, 6b, 6c) is arranged on the ring-shaped measuring electrode (1a, 1b, 1c).

6. Instrument transformer arrangement according to Claim 5,
**characterized in that**
the connecting lug (6a, 6b, 6c) is aligned with a cavity (11) arranged in the insulating body (12, 12a).

7. Instrument transformer arrangement according to Claim 6,
**characterized in that**
the cavity (11) is surrounded by a fitting (7a, 7b, 7c).

8. Instrument transformer arrangement according to one of Claims 1 to 7,
**characterized in that**
a phase conductor (2a, 2b, 2c), which passes through the ring-shaped measuring electrode (1a, 1b, 1c), is surrounded by a shielding electrode (5a, 5b, 5c).

9. Instrument transformer arrangement according to Claim 8,
**characterized in that**
the shielding electrode (5a, 5b, 5c) and/or the phase conductor (2a, 2b, 2c) passes through the insulating body (12, 12a) in fluid-tight fashion.

10. Instrument transformer arrangement according to one of Claims 1 to 9,
**characterized in that**
a plurality of measuring electrodes (1a, 1b, 1c) and a plurality of probes (10a, 10b, 10c) are embedded in an insulating body (12, 12a).

11. Instrument transformer arrangement according to Claims 1 to 10,
**characterized in that**
the insulating body (12, 12a) is surrounded on the lateral surface side by a reinforcing frame (4).

12. Instrument transformer arrangement according to one of Claims 1 to 11,
**characterized in that**
the insulating body (12, 12a) is part of a fluid-tight barrier of an encapsulating housing (15a, 15b).

13. Instrument transformer arrangement according to Claim 12,
**characterized in that**
an electrically insulating fluid is enclosed in the encapsulating housing (15a, 15b).

## Revendications

1. Système de convertisseur de mesure pour le contrôle d'un conducteur ou de plusieurs conducteurs (2a, 2b, 2c) de phase, comportant un capteur de tension et
un capteur de courant, dans lequel le capteur de tension a une électrode (1a, 1b, 1c) de mesure pour la détection d'une tension électrique, dans lequel l'électrode (1a, 1b, 1c) de mesure est de forme annulaire et a un logement (9a, 9b, 9c), dans lequel est placée une sonde (10a, 10b, 10c) du capteur de courant,
dans lequel le logement (9a, 9b, 9c) est conformé en évidement (9a, 9b, 9c) dans l'électrode (1a, 1b, 1c) de mesure et est disposé du côté de la surface latérale extérieure sur l'électrode (1a, 1b, 1c) de mesure, **caractérisé en ce que** l'électrode (1a, 1b, 1c) de mesure et la sonde (10a, 10b, 10c) sont noyées dans un corps (12, 12a) isolant, qui est un isolateur support des / du conducteur(s) (2a, 2b, 2c) de phase.

2. Dispositif de convertisseur de mesure suivant la revendication 1,
**caractérisé en ce que**
la sonde (10a, 10b, 10c) est blindée diélectriquement au moins en partie par l'électrode (1a, 1b, 1c) de mesure.

3. Dispositif de convertisseur de mesure suivant la revendication 1 ou 2,
**caractérisé en ce que**
l'évidement (9a, 9b, 9c) a une cannelure faisant le tour, notamment en soi sans fin.

4. Dispositif de convertisseur de mesure suivant l'une des revendications 1 à 3,
**caractérisé en ce que**
l'électrode (1a, 1b, 1c) de mesure annulaire a un profilage sensiblement en forme de U.

5. Dispositif de convertisseur de mesure suivant l'une des revendications 1 à 4,
**caractérisé en ce que**
sur l'électrode (1a, 1b, 1c) de mesure annulaire est disposé un talon (6a, 6b, 6c) de connexion.

6. Dispositif de convertisseur de mesure suivant la revendication 5,
**caractérisé en ce que**
le talon (6a, 6b, 6c) de connexion est orienté sur une cavité (11) disposée dans le corps (12, 12a) isolant.

7. Dispositif de convertisseur de mesure suivant la revendication 6,
**caractérisé en ce que**
la cavité (11) est entourée d'une armature (7a, 7b, 7c).

8. Dispositif de convertisseur de mesure suivant l'une des revendications 1 à 7,
**caractérisé en ce qu'**
un conducteur (2a, 2b, 2c) de phase traversant l'électrode (1a, 1b, 1c) annulaire de mesure est entouré d'une électrode (5a, 5b, 5c) de blindage.

9. Dispositif de convertisseur de mesure suivant la revendication 8,
**caractérisé en ce que**
l'électrode (5a, 5b, 5c) de blindage et/ou le conducteur (2a, 2b, 2c) de phase traverse le corps (12, 12a) isolant d'une manière étanche au fluide.

10. Dispositif de convertisseur de mesure suivant l'une des revendications 1 à 9,
**caractérisé en ce que**
plusieurs électrodes (1a, 1b, 1c) de mesure et plusieurs sondes (10a, 10b, 10c) sont noyées dans un corps (12, 12a) isolant.

11. Dispositif de convertisseur de mesure suivant la revendication 1 à 10,
**caractérisé en ce que**
le corps (12, 12a) isolant est entouré du côté de la surface latérale d'un cadre (4) de renfort.

12. Dispositif de convertisseur de mesure suivant l'une des revendications 1 à 11,
**caractérisé en ce que**
le corps (12, 12a) isolant est une partie d'une barrière étanche au fluide d'un boîtier (15a, 15b) d'encapsulation.

13. Dispositif de convertisseur de mesure suivant la revendication 12,
**caractérisé en ce qu'**
un fluide isolant électriquement est enfermé dans le boîtier (15a, 15b) d'encapsulation.
